# EUROPEAN PATENT SPECIFICATION

(11) **EP 1 621 058 B1**
(45) Date of publication and mention of the grant of the patent: **21.05.2008**
(21) Application number: 04730548.7
(22) Date of filing: 30.04.2004
(51) Int. Cl.: H05K 13/04

(54) **GLUING METHOD AND DEVICE**
KLEBEVERFAHREN UND -VORRICHTUNG
PROCEDE ET DISPOSITIF DE COLLAGE

(30) Priority: 02.05.2003 DE 10319958; 17.06.2003 DE 10327195
(43) Date of publication of application: 01.02.2006
(73) Proprietor: Ericsson AB, Stockholm (SE)
(72) Inventor: KONRATH, Willibald, D-71554 Cottenweiler (DE); SCHOLL, Klaus, D-71522 Backnang (DE); SCHMELCHER, Haiko, D-74427 Fichtenberg (DE); GORTZEN, Ralf, 71520 Backnang (DE); NAHRING, Martin, D-71554 Weissach im Tal (DE); MULLER, Ulf, D-71522 Backnang (DE)
(74) Representative: Stasiewski, Piotr Grzegorz
(86) International application number: PCT/EP2004/050672
(87) International publication number: WO 2004/098258

(56) References cited:
- EP-A- 0 417 294
- DE-U- 8 808 619
- US-A- 6 129 040
- US-A1- 2002 143 416

## Description

The present invention relates to a method for gluing a circuit component to a circuit board which is applicable in the context of automated manufacture of electronic, optical or hybrid circuits, and a device for carrying out the method.

In the context of automated circuit manufacture, it is known to apply adhesive patches by screen printing to a circuit board on which components are to be mounted, and to place the circuit components on these patches afterwards. Such methods are quick and effective, since they generate all adhesive patches required on a circuit board in a single process step. Since usually the distribution of the adhesive patches on the circuit board is specific for each type of circuit to be manufactured, a specific printing screen is required for each such type. Its manufacture and the exchange of the screens when switching from the manufacture of one type of circuit to another is time consuming, so that this method is economical only for large series.

A further problem of the conventional method is that it is difficult to measure out exactly the quantity of adhesive applied. On the one hand, the quantity of adhesive must be large enough, so that when it is compressed between the circuit board and a circuit component placed thereupon, the base of the circuit component is wetted completely. On the other hand, it must not be so large that a considerable quantity of adhesive is squeezed out at the edges of the circuit component. In particular in RF circuits, serious problems may be caused if circuit components have to be placed at a small pitch that is predefined strictly by requirements concerning high frequency matching between the components. If a considerable quantity of adhesive enters a gap between two closely adjacent circuit components and rises therein, e.g. by capillary effect, between opposing sides of the circuit components, it modifies the specific inductivity of conductors spanning the gap and, thereby, the high frequency matching between the adjacent components.

A further problem of the application of adhesive by a printing technique is that a strictly flat circuit board is necessary. If a circuit comprises hybrid components with a substrate mounted on a circuit board and other circuit components mounted on the substrate, it is not possible to build these hybrid components successively on the circuit board by first gluing the substrate, then applying adhesive and then placing the further circuit components thereupon; instead, such a hybrid component must be pre-assembled completely and must be placed on the circuit board as a finished unit.

US patent publication number 2002/0143416 discloses a method of programming a paste dispensing machine to paste a set of pads disposed on a surface board.

The object of the present invention is to provide a method for gluing circuit components to a circuit board and a device adapted to carry out the method, that allows for highly flexible manufacture of small series, that minimizes conversion times in case of a change of the type of circuit to be manufactured and that can be used for building hybrid components successively on a circuit board.

The object is achieved by a method having the features of claim 1 and a device having the features of claim 17.

By a matched selection of the distance of the first line from the edge of the circuit component to be placed and the quantity of adhesive to be applied on said line, an undesired, excessive emergence of adhesive along said edge may be reliably prevented, even if the meterability of the quantity of adhesive is poor. By an appropriate choice of the position of the further lines on the base area, a large area surface bond is achieved.

If the circuit component to be glued has two parallel edges, it is appropriate to apply adhesive in parallel to both edges along first lines in the selected distance from each edge and in the selected quantity. The area between the parallel first lines is then appropriately filled with parallel and equidistant adhesive lines. Air that may be present between the circuit board, the circuit component and two adhesive lines when the circuit component is placed on the circuit board can escape along the spaces between the lines when the circuit component is pressed against the circuit board.

The number of equidistant lines is preferably selected such that a distance of the lines from each other results that is approximately twice the distance selected in step a). Thus, by pressing the circuit component, a continuous or almost continuous adhesive layer can be achieved on the whole area of the circuit component without causing a substantial quantity of adhesive to be squeezed out from below the circuit component.

According to a first embodiment of the method, the adhesive is applied continuously along each line. This may for example be done using a hollow needle that has adhesive supplied to it by a pump, which operates continuously while the needle moves along the line. This procedure is preferred for gluing circuit components that have edges of several millimetres or more length.

If the adhesive supply is interrupted at the end of a line, a drop may form there, which, when pressing the circuit component, might emerge at an edge thereof. In order to prevent formation of such drops, it is preferred to stop the adhesive-metering pump at a predefined distance before reaching the end point of each line or, alternatively, to reverse the feeding direction of the pump, so that adhesive which is not yet applied is withdrawn towards the pump. Another possibility to prevent formation of drops is to reverse the direction of movement of the needle at each end of a line and, meanwhile, to stop the pump, so that adhesive is distributed along the line.

According to a second embodiment of the method, which is preferred for gluing small circuit components or circuit components having a predefined low adhesive layer thickness, adhesive is applied along each line in the form of equally spaced dots.

The distance of the dots of each line from each other preferably corresponds to approximately twice the distance selected in step a), so that a square lattice of adhesive dots results.

In order to bond the circuit components on their entire bottom area, including the corners, an additional adhesive dot should be placed in each corner of said area, preferably along a bisect of this corner. The distance of this additional dot from an adjacent edge should be less than the distance selected in step a).

For placing the adhesive dots, a tip can be used that is continuously supplied with adhesive, such as the above-mentioned needle supplied by an adhesive pump. The control of the quantity of adhesive in every individual dot then results from the ratio of the throughput of the pump to the frequency with which the dots are placed. In order to generate particularly small adhesive dots, a discontinuous procedure is particularly appropriate, in which in an alternating fashion, adhesive is applied to a tip and then the tip is brought into contact with the circuit board. The application may in particular be done by contacting the tip with a quantity of adhesive in a reservoir. The quantity of adhesive contained in a dot depends, amongst other things, on the surface area of the tip that is brought into contact with the adhesive in the reservoir and with the circuit board and may reach volumes of 0.2 nl and less.

In order to meter out the adhesive as exactly as possible in spite of eventual variations of the viscosity or other properties of the adhesive and of a pump used for applying it, it is preferred to apply a test line of the adhesive before carrying out step b) and to judge the quantity of glue contained therein by non-contacting measurement. Such a judgement can be carried out in various stages of the method. If it is done before step a), the judged quantity of adhesive can be selected as the quantity of adhesive to be metered out in step a), and line distances and/or the speed of the adhesive applying tip are adapted thereto. The judgement may also be carried out between steps a) and b), in which case it is used to realize exactly the previously determined quantity of glue to be applied by controlling the speed of the tip or the feeding rate of the pump.

If the adhesive lines are formed of individual dots, such a judgment of the quantity of adhesive may also be carried out based on a test dot; and the line distances and/or the dot distances within a line and/or, in the case of using a continuously operating pump, the quantity of adhesive within a dot may be defined based on the results of the judgment.

Further features and advantages of the invention will become apparent from the subsequent description of embodiments referring to the appended drawings.
Fig. 1 is a schematic top view of a placing machine as an embodiment of a device according to the invention for applying adhesive to a circuit board;
Fig. 2 is a schematic side view of an adhesive-dispensing head;
Fig. 3A is a schematic section of the adhesive-dispending head in a first position;
Fig. 3B is a schematic section of the adhesive-dispending head in a second position;
Fig. 4 is a flow chart of an operating method of the placing machine according to the invention; and
Fig. 5 is a top view of a circuit board with adhesive applied to it according to the method of the invention.

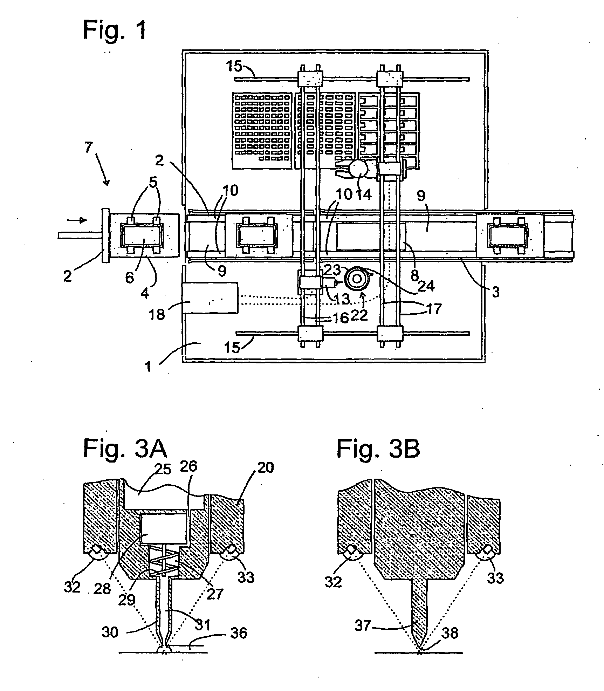

The placing machine shown in Fig. 1 comprises two belt conveyor means 2, 3 mounted on a vibration-dampened table top 1 for feeding circuit carriers 4 on which a circuit board 6 to be assembled is fixed by means of claws 5, from a magazine loader 7, not shown in detail, to a placing location 8 and, when the placing is finished, out of the placing machine for further processing. The belt conveyor means 2, 3 both have an elongate horizontal plate 9, that has driven belts 10 wound around it in an edge region, on which rest the circuit carriers 4 to be conveyed. The circuit carriers 4 are guided with little clearance between lateral flanks 11.

The placing location 8 is formed by a vertically displaceable table which is inserted into the plate 9 of belt conveyor means 3 and which, for placing, is raised against an abutment, in order to lift the circuit carrier 4 off the belts 10 and to bring it into an exactly determined and reproducibly settable height.

A dispenser 13 for adhesive and a gripper 14 are mounted to rails 15 so as to be movable in parallel to the conveying direction of belt conveyor means 2, 3 and at rails 16, 17 so as to be movable transversely with respect to the conveying direction. Further, the height of dispenser 13 and gripper 14 is controllable. A control circuit 18 controls the movements of dispenser 13 and gripper 14 based on construction data of the circuit to be mounted on circuit board 6. In order to receive these construction data, the control circuit 18 is equipped with a digital interface and/or a reading device for portable data carriers (not shown).

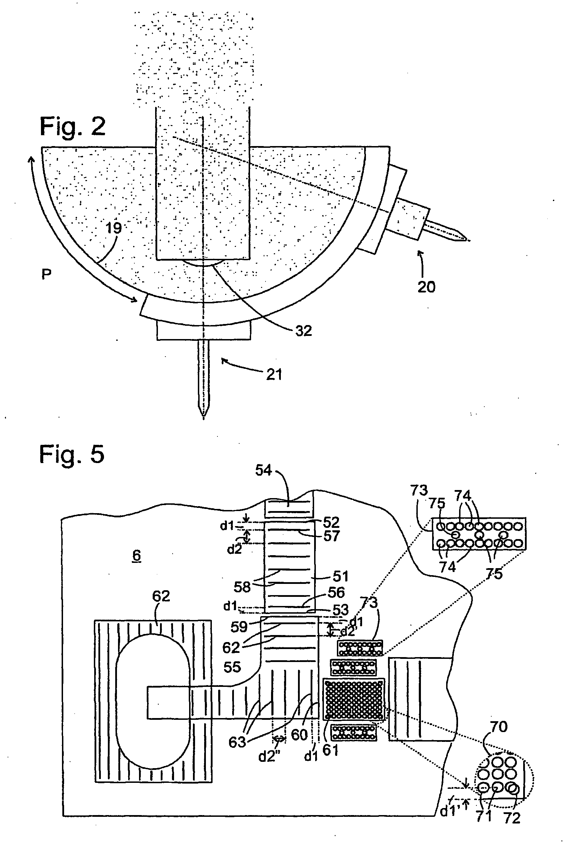

Fig. 2 is a side view of the lower region of dispenser 13. Two dispenser heads 20, 21 are displaceable between two positions along a rail 19 which here is shown to have a semicircular configuration. At opposite sides of rail 19 and immobile with respect to it, a laser diode 32 and an optical sensor 33 (concealed in Fig. 2, see Figs. 3A, 3B) are located.

The laser diode 32 and the sensor 33 are oriented towards the tip of a needle of a dispenser head located between them, namely dispenser head 21 in the configuration of Fig. 2, and form a non-contact measuring device for measuring a distance of the dispenser from a surface underneath the relevant dispenser head.

Fig. 3A shows a schematic section of the lower region of dispenser head 20. An upper region of dispenser head 20, which is not shown completely, contains an adhesive tank 25, from which a duct 26 leads to a pump which is here formed by a chamber 27 in which a worm 29 rotatably driven by a motor 28 is accommodated. At the bottom side of dispenser head 20, a hollow needle 30 projects downward. An outlet channel 31 connected to chamber 27 extends through needle 30.

The dispenser head 20 is useful for applying adhesive in the form of continuous lines or individual dots. In order to form a continuous adhesive line 36 on a circuit board surface, the control circuit 18 controls the movement of the dispenser 13 along the line 36, on the one hand, and the quantity of adhesive conveyed by the worm 29, on the other, such that the adhesive line 36 is formed with a desired cross section. The higher the feeding rate is and the slower the movement of dispenser 13 is, the larger is the cross section; the faster the dispenser moves and the smaller the feeding rate is, the smaller is the cross section.

In order to apply adhesive dots, either the worm 29 is driven intermittently so as to deliver a certain amount of adhesive per dot applied, or the worm 29 rotates continuously, while the needle 30 is dipped with a predefined, constant frequency against the surface that is to be supplied with adhesive.

When the adhesive is applied continuously or intermittently, the height of the needle 30 above the circuit board is continuously controlled using the laser diode 32 and the sensor 33. This allows the tip of the needle 30 to move at a very small distance from the surface of the circuit board while applying the adhesive continuously to the circuit board, so that very finely structured adhesive patterns may be formed on the surface, and/or allows the needle 30 to stop each time at a same distance shortly before touching the surface when dipping the needle 30, so that adhesive dots having an exactly reproducible shape and a same volume are formed.

The dispenser head 21 shown in Fig. 3B is solid. Its needle 37 has a flat end surface 38 of approx. 75 mm in diameter.

The dispenser head 21 is provided for dipping its tip 38 alternately into an adhesive pan and then onto the surface where an adhesive dot is to be formed. The adhesive pan 22, shown schematically in top view in Fig. 1, is formed as a flat dish that rotates step by step and in which a groove 23 that receives the adhesive is formed concentrically with respect to the axis of rotation. A doctor blade 24 dives into the groove 23 and upon each rotation flattens the surface of the adhesive deformed by dipping the needle 37 into it. In this way, each time when the needle 37 is dipped into the pan, it meets a fresh adhesive surface at a constant level, so that the quantity of adhesive received in each dive remains constant. Using the laser diode 32 and the sensor 33, the diving depth of the needle 37 in the adhesive of groove 23 and the distance from the circuit board when dipping onto it are held constant.

The gripper 14 has two gripping jaws that are moveable with respect to each other, for gripping circuit components from supports located on the table top 1 and pressing these components onto the circuit regions of a circuit board that had adhesive lines or dots applied to them before. Pressing time and force are controllable by the control circuit 18.

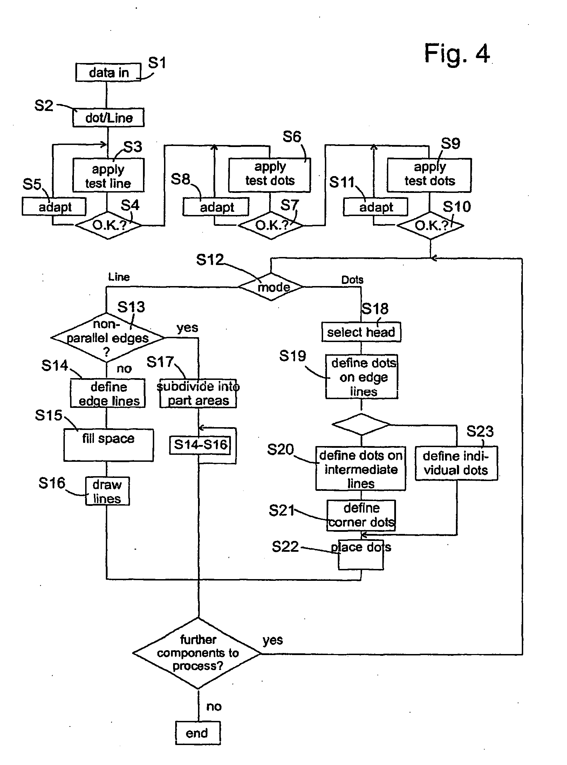

In the following, the operation of the control circuit 18 for applying adhesive onto a circuit board are described based on the flowchart of Fig. 4. In a first step S1, the control circuit receives CAD data that comprises geometric parameters of the circuit board and of circuit components to be mounted thereupon. This data may be fed into the control circuit 18 by the digital interface or by the reading device. The circuit components specified in the CAD data may be intended for mounting them directly on the circuit board or for mounting on another circuit component already mounted to the circuit board, for example a ceramic substrate.

In step S2, the control circuit decides for each component defined in the CAD data if the adhesive for gluing it is to be applied dot by dot or line by line. A predefinition of the type of gluing can already be contained in the CAD data; if this is not the case, the control circuit 18 decides the type of gluing based on the dimensions of the circuit component. In the case of an edge length of less than a couple of millimetres, in particular if electronic components are concerned, dot by dot gluing is selected. In case of large components such as substrates, screening elements etcetera line by line gluing is chosen.

Before it is begun to apply adhesive to a circuit board that is to be assembled, a calibration of the dispenser 13 may be carried out. This is useful in order to ensure a reproducible metering of the adhesive in spite of its viscosity, which may change with time. When a pot of conventional adhesive has been opened, there is a limited "pot lifetime" for which the manufacturer guarantees the effectiveness of the adhesive. However, it is not excluded that under unfavourable climatic conditions the adhesive reaches a viscosity at which correct metering of the adhesive is no longer possible or even the pump is damaged before the end of the pot lifetime. The calibration allows to detect such a case and, in case of need, to replace the adhesive. Further, it allows determination of whether, under favourable conditions, the adhesive is still useable after the end of the pot lifetime and may still be applied.

The calibration may be carried out for dot-by-dot application using head 20, for dot-by-dot application using head 21 or for line-by-line application or for only one or two of these alternatives if the other is not used in the current assembly process.

When calibrating line-by-line application, the control circuit 18 drives the dispenser head 20 across a test plate at a speed and a feeding rate of worm 21 that agree approximately with the feeding rate and speed during the subsequent application of the adhesive to circuit boards, and applies an adhesive line to the test plate (step S3). Subsequently, the dispenser 13 is moved transversely across the applied adhesive line, while continuously detecting the distance of the dispenser head 20 from the facing surface of the test plate using the laser diode 32 and the light sensor 33, in order to detect the cross section area of the adhesive line, and, thus, the quantity of adhesive applied per length unit. If it is found in step S4 that the detected amount of adhesive does not agree with a desired quantity, the feeding rate of worm 29 and/or the speed of movement of the dispenser head 20 are adapted in proportion to a relative discrepancy between the desired and detected adhesive quantities (step S5). This process may be iterated until a sufficient agreement between desired and applied adhesive quantities is achieved.

In case of dot-by-dot application using dispenser head 20, one or more test dots are formed on the test plate under the conditions intended for the subsequent placing operation (S6), and the volume is compared to a desired value (S7). This quantity may be adapted by varying the feeding rate of worm 29 and/or the frequency with which the dots are dipped (S8).

In case of dot application using dispenser head 21, test dots are also placed, and their volume is measured (S9). The volume of the dots may be set to a desired value by adapting the dipping depth of the needle tip 38 of dispenser head 21 into adhesive pot 22 and, thus, the amount of adhesive taken out at each dive into the pot 22 (S11).

If the resolution achieved using the laser diode 32 and the light sensor 33 is not sufficient for measuring the volumes of the applied lines or dots, it is also possible to measure these outside the manufacturing apparatus of the invention and to input the thus obtained values into the control circuit 18 in order to set the applied quantity of adhesive to the desired value.

In step S12, the control circuit selects one among the circuit components specified in the CAD data, for which an adhesive pattern is to be applied on the circuit board to be mounted.

First, it shall be assumed that the mode to be applied for this circuit component is the application of adhesive lines using dispenser head 20. In this case, control circuit 18 determines in step S 13 from the CAD-data those edges of the circuit component that are crossed by an RF signal line. If the selected circuit component is for example the substrate 51 of Fig. 5, there are two parallel edges 52, 53, across which a RF signal line (not shown) extends to a neighbouring substrate 54, 55, respectively. A distance d1 that must exist between the edges 52, 53 and the closest adjacent adhesive lines 56, 57 is defined for all substrates to be mounted on circuit board 6 depending on a desired thickness of the adhesive layer between the substrate 51 and the circuit board 6 underneath and on the previously calibrated amount of adhesive per length unit. In the Figure, the distance d1 is the same for the substrates 51, 54, 55. If the desired thicknesses of the adhesive layer are different for the various substrates, different distances d1 will be selected. In step S14, the control circuit calculates the coordinates of adhesive lines 56, 57 from the position of the edges 52, 53 and the distance d1.

In step S15, the coordinates of equidistant lines 58 are calculated, by which the space between the lines 56, 57 is filled. The control circuit 18 selects the number of such inserted lines 58 such that the distance d2 between adjacent lines 56, 57, 58 differs as little as possible from 2 x d1. Thus, an essentially complete wetting of the bottom side of substrate 51 with adhesive is achieved without incurring the risk that when pressing the substrate 21, adhesive will be squeezed out under the edges 52, 53.

In step S16, the adhesive lines 56, 58, 57 are applied to the circuit board 6 at the calculated co-ordinates.

In an RF circuit, there may be substrates such as substrate 57, which have RF signal transitions at non-parallel edges. For example, the substrate 55 has an RF-signal transition at its edges 59, 60 towards substrate 51 and towards a circuit component 61, respectively. In this case, the control circuit 18 branches from step S13 to step S17, where a sub-division of the base area of substrate 55 into several part areas is carried out, each of which has signal transitions only at one edge or at parallel edges. In these sub-areas, the steps S14 to S16 described above for substrate 51 are carried out one after the other. From this, two groups of mutually parallel adhesive lines 62, 63 are obtained for substrate 54, in each of which the distance d1 between the outermost line and the edge 59 or 60, respectively, is the same as between edge 52 and line 57, and in which the distances d2', d2" of lines from one another are determined according to the same method as described above for the distance d2 but may differ from d2 and from one another.

In the same way, the control circuit 18 also generates patterns of parallel adhesive lines for circuit components that carry no RF signal, such as a waveguide cover 62 into which a free end of substrate 55, provided with an antenna conductor (not shown), projects.

If the edge lengths of a circuit component to be glued are small, in the order of 5 to 6 times the distance d1, it is difficult to achieve a sufficient wetting of the contact area between the circuit component and its support by the line-by-line adhesive application method described above. Since the small sized-components are often active components that cause power losses, it is particularly important to have a full-area thermally conductive contact with the support by an adhesive layer of a predefined, low thickness. This applies in particular to the circuit component 61 of Fig. 5. Here, the control unit 18 in step S12 opts for an adhesive pattern formed of individual dots. Such a pattern may be formed using any of the two dispenser heads 20, 21. If the dimensions of the circuit component 61 are very small, the control circuit selects head 20 in step S18, else head 21. The conditions to be fulfilled when calculating the dot patterns are similar to those in case of generating lines: the amount of glue per dot is predefined by the calibration, and from this pre-definition results a fixed distance d1' which the dots must have from an edge which is crossed by an RF signal, in order to guarantee that when pressing the circuit component, the adhesive will spread to the edge thereof, and on the other hand, to prevent that, when pressing, adhesive is squeezed out at this edge. In order to guarantee that dots formed in a line merge when the circuit component is pressed, their distance from one another should not be greater than 2d1'; the same applies for the distance of the dot lines from one another. Based on these conditions, the control circuit 18 calculates the coordinates of adhesive dots on two lines adjacent to two edges of the circuit component (S19), and afterwards, of adhesive dots on lines distributed equidistantly between said two lines (S20).

As can been seen clearly in the enlarged detail 70, at the corners of the circuit component 61, a shifted second adhesive dot 72 is placed over the last adhesive dot 71 of a line (S21, S22). The shifted adhesive dot 72 is closer to the edges of the circuit component 61 than the adhesive dot 71 and is located on the bisectrix of the corner, so that the adhesive contained in it fills the corner of the circuit component practically completely when the circuit component 61 is pressed against the circuit board 6. In this way, an adhesive wetting of the bottom side of circuit component 1 of almost 100 % can be achieved.

A modified adhesive distribution, which is selected by a control circuit 18 specifically in case of small sized circuit components, is illustrated by means of the circuit component 73, which is shown enlarged in Fig. 5. For gluing this component, two lines of dots 74 that are parallel to the longitudinal edges of the circuit components 73 are calculated (S19) and are placed on the circuit board 6. Just as in case of circuit component 61, the distance d1' of the dots 74 from the longitudinal edges is chosen so that when the circuit component 73 is pressed, all dots 74 in a line merge into a continuous strip, without adhesive being squeezed out along the longitudinal edges of circuit component 73. Since the distance of the two lines from one another is larger than 2d1' but less than 4d1', there is the risk that the dots 74 of the two lines do not merge when pressing, on the other hand, there is no space for placing a further line of dots. Therefore, in the space between the two lines of dots, individual adhesive dots 75 are selectively placed at locations where the power loss of the circuit component 73 is particularly high, so that even if the bottom side of circuit component 73 is not completely wetted with adhesive after pressing, an efficient heat removal from the circuit component to the circuit board 6 is ensured.

In simplified embodiments of the invention, the head 20 of dispenser 13 may not exist, so that placing dots is possible with head 21 only, or a simplified control circuit 18 may be provided which supports placing dots only by means of head 20, but not by head 21.

## Claims

1. A method for gluing a circuit component (51, 54, 55, 61, 73) to a circuit board (6), the circuit component (51, 54, 55, 61, 73) having a bottom area with at least one edge (52, 53, 59, 60) for bringing into contact with the circuit board, the method comprising the steps of:
a) selecting the distance (d1) between the edge (52, 53, 59, 60) and a first line (56, 57, 62, 63) parallel to said edge and a quantity of adhesive to be applied along said line (56, 57) per length unit, so that when placing the circuit component (51, 55) on the circuit board (6), the adhesive will advance to the edge (52, 53, 59, 60) but not to a second circuit component (54, 55, 61) adjacent to said edge;
b) applying (S14, S16; S19, S22) the adhesive in the selected quantity along the first line (56, 57, 62, 63);
c) applying (S15, S16; S20, S22) further adhesive along further lines (58, 62, 63) parallel to said first line at a larger distance from the edge (52, 53, 59, 60) than the one selected for the first line; and
d) placing the circuit component (51, 54, 55, 61) on the circuit board (6).

2. The method of claim 1, wherein the bottom area has at least two parallel edges (52, 53), **characterized in that** step b) (S14, S16; S19, S22) is carried out for first lines (56, 57) parallel to the two edges, and that in step c) (S15, S16; S20, S22) the adhesive is applied as equidistant parallel lines (58) between said two first lines (56, 57).

3. The method of claim 2, **characterized in that** the quantity of adhesive per length unit is selected identical for all lines (56, 57, 62, 63), and that the number of equidistant lines is selected such (S15) that their distance (d2) is essentially twice the distance (d1) selected in step a).

4. The method according to one of the preceding claims, **characterized in that** the adhesive is applied continuously (S16) by means of a tip (30), which is displaceable along each line.

5. The method of claim 4, **characterized that** at the end of each line, the feeding direction of an adhesive feeding pump (28, 29) is reversed.

6. The method of claim 4, **characterized in that** the direction of movement of the tip (30) is reversed when reaching the end of a line (56, 57, 58, ...).

7. The method according to one of claims 1 to 3, **characterized in that** the adhesive is applied along each line by equally spaced dots (71, 74) (S22).

8. The method of claim 7, **characterized in that** the distance of the dots (71, 74) of each line among each other is essentially twice the distance (d1') selected in step a).

9. The method of claims 7 or 8, **characterized in that** in a corner of the bottom area an additional dot (72) is placed (S21, S22).

10. The method of claim 9, **characterized in that** the additional dot (72) is placed on a bisectrix of the corner.

11. The method of claim 9 or 10, **characterized in that** the distance of the additional dot (72) from an adjacent edge is selected smaller than the distance (d1') selected in step a).

12. The method of one of claims 7 or 11, **characterized in that** in a space between two lines filling dots (75) are placed (S23).

13. The method of one of claims 7 to 12, **characterized in that** the dots (71, 72, 74, 75) are placed using a tip (30) which is continuously supplied with adhesive.

14. The method according to one of claims 7 to 12, **characterized in that** dots (71, 72, 74, 75) are placed (S22) by alternately applying adhesive to the tip (37) and bringing the tip (37) into contact with the circuit board.

15. The method of claim 4, 5 or 13, **characterized in that** before step b) at least one test line of adhesive is applied (S3), that the amount of adhesive contained in the test line is judged by contactless measurement of the test line (S4), and that the throughput of the pump (28, 29) and/or the speed of the tip (30, 37) while applying the adhesive and/or the distances (d1, d2, ...) of the lines are determined (S5) based on the result of the judgement.

16. The method of claim 13 or 14, **characterized in that** before step b) at least one test dot of adhesive is applied (S6, S9), that the amount of adhesive contained in the test dot is judged by contactless measurement of the test dot (S7, S10), and that the distances of the lines and/or the distances of the dots (71, 74) within a line are determined based on the result of the judgement (s8, S11).

17. A device for applying adhesive on a circuit board according to the method of one of the preceding claims, comprising a robot arm, an application tip (30,37) held at a free end of the robot arm and a control circuit (18) for controlling the movement of the application tip (30,37), **characterised by** the control circuit (18) being adapted
- to receive data concerning position and shape of the circuit component (51,54,55,61,73) to be glued to the circuit board (6), which specify at least the position of an edge (52,53,59,60) of the circuit component (51,54,55,61,73), by a digital interface,
- and to determine, based on these data, a position of the first line (56,57,62,63),
- and to control the movement of the application tip (30,37) along said first line and subsequently control the movement of the application tip (30,37) along further lines (58,62,63) parallel to said first line at a larger distance from the edge (52,53,59,60) than the one selected for the first line.

## Patentansprüche

1. Verfahren zum Kleben eines Schaltungselements (51, 54, 55, 61, 73) an eine Leiterplatte (6), wobei das Schaltungselement (51, 54, 55, 61, 73) einen Bodenbereich mit mindestens einer Kante (52, 53, 59, 60) zum Herstellen eines Kontakts mit der Leiterplatte aufweist, wobei das Verfahren die folgenden Schritte umfasst:
a) Wählen des Abstands (d1) zwischen der Kante (52, 53, 59, 60) und einer ersten Linie (56, 57, 62, 63), die zu der Kante parallel ist, und einer Menge an Klebstoff, die entlang der Linie (56, 57) pro Längeneinheit aufzutragen ist, so dass, wenn das Schaltungselement (51, 55) auf der Leiterplatte (6) angebracht wird, der Klebstoff bis zu der Kante (52, 53, 59, 60) vordringt, jedoch nicht bis zu einem zweiten Schaltungselement (54, 5, 61), das der Kante benachbart ist;
b) Auftragen (S14, S16; S19, S22) des Klebstoffes in der gewählten Menge entlang der ersten Linie (56, 57, 62, 63);
c) Auftragen (S15, S16; S20, S22) von weiterem Klebstoff entlang weiterer Linien (58, 62, 63), die parallel zu der ersten Linie in einem Abstand von der Kante (52, 53, 59, 60) verlaufen, der größer ist als der für die erste Linie gewählte; und
d) Anbringen des Schaltungselements (51, 54, 55, 61) auf der Leiterplatte (6).

2. Verfahren nach Anspruch 1, wobei der Bodenbereich mindestens zwei parallele Kanten (52, 53) hat, **dadurch gekennzeichnet, dass** Schritt b) (S14, S16; S19, S22) für erste Linien (56, 57) ausgeführt wird, die zu den zwei Kanten parallel sind, und dass in Schritt c) (S15, S16; S20, S22) der Klebstoff als äquidistante parallele Linien (58) zwischen den zwei ersten Linien (56, 57) aufgetragen wird.

3. Verfahren nach Anspruch 2, **dadurch gekennzeichnet, dass** die Menge an Klebstoff pro Längeneinheit für alle Linien (56, 57, 62, 63) identisch gewählt wird und dass die Anzahl äquidistanter Linien derart gewählt wird (S15), dass ihr Abstand (d2) im Wesentlichen das Zweifache des Abstands (d1) beträgt, der in Schritt a) gewählt wurde.

4. Verfahren nach einem der vorhergehenden Ansprüche, **dadurch gekennzeichnet, dass** der Klebstoff kontinuierlich (S16) mittels einer Spitze (30) aufgetragen wird, welche entlang jeder Linie verschiebbar ist.

5. Verfahren nach Anspruch 4, **dadurch gekennzeichnet, dass** am Ende jeder Linie die Zuführungsrichtung einer Klebstoffzuführpumpe (28, 29) umgekehrt wird.

6. Verfahren nach Anspruch 4, **dadurch gekennzeichnet, dass** Bewegungsrichtung der Spitze (30) umgekehrt wird, wenn das Ende einer Linie (56, 57, 58, ...) erreicht wird.

7. Verfahren nach einem der Ansprüche 1 bis 3, **dadurch gekennzeichnet, dass** der Klebstoff entlang jeder Linie durch in gleichen Abständen angeordnete Tupfer (71, 74) aufgetragen wird (S22).

8. Verfahren nach Anspruch 7, **dadurch gekennzeichnet, dass** der Abstand der Tupfer (71, 74) jeder Linie voneinander im Wesentlichen das Zweifache des Abstands (d1') beträgt, der in Schritt a) gewählt wurde.

9. Verfahren nach Anspruch 7 oder 8, **dadurch gekennzeichnet, dass** in einer Ecke des Bodenbereiches ein zusätzlicher Tupfer (72) angebracht wird (S21, S22).

10. Verfahren nach Anspruch 9, **dadurch gekennzeichnet, dass** der zusätzliche Tupfer (72) auf einer Winkelhalbierenden des Winkels am Eckpunkt angebracht wird.

11. Verfahren nach Anspruch 9 oder 10, **dadurch gekennzeichnet, dass** der Abstand des zusätzlichen Tupfers (72) von einer benachbarten Kante kleiner als der Abstand (d1') gewählt wird, der in Schritt a) gewählt wurde.

12. Verfahren nach einem der Ansprüche 7 oder 11, **dadurch gekennzeichnet, dass** in einem Zwischenraum zwischen zwei Linien Fülltupfer (75) angebracht werden (S23).

13. Verfahren nach einem der Ansprüche 7 bis 12, **dadurch gekennzeichnet, dass** die Tupfer (71, 72, 74, 75) unter Verwendung einer Spitze (30) angebracht werden, welche kontinuierlich mit Klebstoff versorgt wird.

14. Verfahren nach einem der Ansprüche 7 bis 12, **dadurch gekennzeichnet, dass** die Tupfer (71, 72, 74, 75) angebracht werden (S22), indem abwechselnd Klebstoff auf die Spitze (37) aufgetragen wird und die Spitze (37) in Kontakt mit der Leiterplatte gebracht wird.

15. Verfahren nach Anspruch 4, 5 oder 13, **dadurch gekennzeichnet, dass** vor Schritt b) mindestens eine Testlinie von Klebstoff aufgetragen wird (S3), dass die in der Testlinie enthaltene Menge an Klebstoff durch kontaktlose Messung der Testlinie beurteilt wird (S4) und dass der Durchsatz der Pumpe (28, 29) und/oder die Geschwindigkeit der Spitze (30, 37) während des Auftragens des Klebstoffes und/oder die Abstände (d1, d2, ...) der Linien auf der Grundlage des Ergebnisses der Beurteilung festgelegt werden (S5).

16. Verfahren nach Anspruch 13 oder 14, **dadurch gekennzeichnet, dass** vor Schritt b) mindestens ein Testtupfer von Klebstoff aufgetragen wird (S6, S9), dass die in dem Testtupfer enthaltene Menge an Klebstoff durch kontaktlose Messung des Testtupfers beurteilt wird (S7, S10) und dass die Abstände der Linien und/oder die Abstände der Tupfer (71, 74) innerhalb einer Linie auf der Grundlage des Ergebnisses der Beurteilung festgelegt werden (S8, S11).

17. Vorrichtung zum Auftragen von Klebstoff auf eine Leiterplatte entsprechend dem Verfahren nach einem der vorhergehenden Ansprüche, welche einen Roboterarm, eine Auftragspitze (30, 37), die an einem freien Ende des Roboterarmes gehalten wird, und eine Steuerschaltung (18) zum Steuern der Bewegung der Auftragspitze (30, 37) umfasst, **dadurch gekennzeichnet, dass** die Steuerschaltung (18) dazu eingerichtet ist,
- Daten, welche Position und Form des an die Leiterplatte (6) zu klebenden Schaltungselements (51, 54, 55, 61, 73) betreffen und welche mindestens die Position einer Kante (52, 53, 59, 60) des Schaltungselements (51, 54, 55, 61, 73) vorgeben, über eine digitale Schnittstelle zu empfangen,
- und auf der Grundlage dieser Daten eine Position der ersten Linie (56, 57, 62, 63) festzulegen,
- und die Bewegung der Auftragspitze (30, 37) entlang der ersten Linie zu steuern und anschließend die Bewegung der Auftragspitze (30, 37) entlang weiterer Linien (58, 62 63) zu steuern, die parallel zu der ersten Linie in einem Abstand von der Kante (52, 53, 59, 60) verlaufen, der größer ist als der für die erste Linie gewählte.

## Revendications

1. Procédé de collage d'un composant de circuit (51,54,55,61,73) sur une carte de circuit (6), le composant de circuit (51,54,55,61,73) comportant une région inférieure avec au moins un bord (52,53,59,60) à amener en contact avec la carte de circuit, le procédé comprenant les étapes consistant à :
a) sélectionner la distance (d1) entre le bord (52,53,59,60) et une première ligne (56,57,62,63) parallèle audit bord et une quantité de colle à appliquer le long de ladite ligne (56,57) par unité de longueur, de telle sorte que, lors du placement du composant de circuit (51,55) sur la carte de circuit (6), la colle avancera vers le bord (52,53,59,60) mais pas vers un second composant de circuit (54,55,61) adjacent audit bord ;
b) appliquer (S14,S16 ;S19,S22) la colle dans la quantité sélectionnée le long de la première ligne (56,57,62,63) ;
c) appliquer (S15,S16 ;S20,S22) davantage de colle le long des autres lignes (58,62,63) parallèles à ladite première ligne à une distance plus grande par rapport au bord (52,53,59,60) que celle sélectionnée pour la première ligne ; et
d) placer le composant de circuit (51,54,55,61) sur la carte de circuit (6).

2. Procédé selon la revendication 1, dans lequel la région inférieure comporte au moins deux bords parallèles (52,53), **caractérisé en ce que** l'étape b) (S14,S16 ;S19,S22) est exécutée pour des premières lignes (56,57) parallèles aux deux bords, et **en ce que** à l'étape c) (S15,S16 ;S20,S22) la colle est appliquée sous forme de lignes parallèles équidistantes (58) entre lesdites deux premières lignes (56,57).

3. Procédé selon la revendication 2, **caractérisé en ce que** la quantité de colle par unité de longueur est choisie à l'identique pour toutes les lignes (56,57,62,63) et **en ce que** le nombre de lignes équidistantes est choisi de telle sorte (S15) que la distance (d2) soit essentiellement le double de la distance (d1) sélectionnée à l'étape a).

4. Procédé selon une des revendications précédentes, **caractérisé en ce que** la colle est appliquée en continu (S16) au moyen d'une pointe (30), qui est déplaçable le long de chaque ligne.

5. Procédé selon la revendication 4, **caractérisé en ce que** à l'extrémité de chaque ligne, la direction d'injection d'un pompe d'injection de colle (28,29) est inversée.

6. Procédé selon la revendication 4, **caractérisé en ce que** la direction de mouvement de la pointe (30) est inversée lorsqu'elle atteint l'extrémité d'une ligne (56,57,58,...).

7. Procédé selon une des revendications 1 à 3, **caractérisé en ce que** la colle est appliquée le long de chaque ligne par des points espacés de manière égale (71,74)(S22).

8. Procédé selon la revendication 7, **caractérisé en ce que** la distance des points (71,74) de chaque ligne les uns par rapport aux autres est essentiellement le double de la distance (d1') sélectionnée à l'étape a).

9. Procédé selon les revendications 7 ou 8, **caractérisé en ce que** dans un coin de la région de base, un point supplémentaire (72) est placé (S21,S22).

10. Procédé selon la revendication 9, **caractérisé en ce que** le point supplémentaire (72) est placé sur une bissectrice du coin.

11. Procédé selon la revendication 9 ou 10, **caractérisé en ce que** la distance du point supplémentaire (72) par rapport à un bord adjacent est choisie comme étant plus petite que la distance (d1') sélectionnée à l'étape a).

12. Procédé selon une des revendications 7 ou 11, **caractérisé en ce que** dans un espace entre deux lignes, des points de remplissage (75) sont placés (S23).

13. Procédé selon une des revendications 7 à 12, **caractérisé en ce que** les points (71,72,74,75) sont placés en utilisant une pointe (30) qui est alimentée en colle en continu.

14. Procédé selon une des revendications 7 à 12, **caractérisé en ce que** les points (71,72,74,75) son placés (S22) en appliquant en alternance de la colle sur la pointe (37) et en amenant la pointe (37) en contact avec la carte de circuit.

15. Procédé selon la revendication 4,5 ou 13, **caractérisé en ce que** avant l'étape b) au moins une ligne test de colle est appliquée (S3), la quantité de colle contenue dans la ligne test est estimée par une mesure sans contact de la ligne de test (S4) et le débit de la pompe (28,29) et/ou la vitesse de la pointe (30,37) pendant l'application de la colle et/ou les distances (d1,d2,...) des lignes sont déterminées (S5) sur la base du résultat de l'estimation.

16. Procédé selon la revendication 13 ou 14, **caractérisé en ce que** avant l'étape b) au moins un point test de colle est appliqué (S6,S9), la quantité de colle contenue dans le point test est estimée par une mesure sans contact du point test (S7,S10) et les distances des lignes et/ou les distances des points (71,74) à l'intérieur d'une ligne sont déterminées sur la base du résultat de l'estimation (S8,S11).

17. Dispositif pour appliquer de la colle sur une carte de circuit selon le procédé d'une des revendications précédentes, comprenant un bras de robot, une pointe d'application (30,37) maintenue à une extrémité libre du bras de robot et un circuit de commande (18) pour commander le mouvement de la pointe d'application (30,37), **caractérisé en ce que** le circuit de commande (18)
- reçoit des données relatives à la position et la forme du composant de circuit (51,54,55,61,73) à coller sur la carte de circuit (6), qui spécifient au moins la position d'un bord (52,53,59,60) du composant de circuit (51,54,55,61,73) par une interface numérique,
- détermine, sur la base de ces données, une position de la première ligne (56,57,62,63),
- et commande le mouvement de la pointe d'application (30,37) le long de ladite première ligne et commande ensuite le mouvement de la pointe d'application (30,37) le long des autres lignes (58,62,63) parallèles à ladite première ligne à une distance plus grande par rapport au bord (52,53 ;59,60) qu'une distance sélectionnée pour la première ligne.
